(19) **Europäisches Patentamt / European Patent Office / Office européen des brevets**

(11) **EP 4 611 261 A1**

(12) **EUROPEAN PATENT APPLICATION**

(43) Date of publication:
**03.09.2025 Bulletin 2025/36**

(21) Application number: **24160712.6**

(22) Date of filing: **29.02.2024**

(51) International Patent Classification (IPC):
**H03K 17/95** $^{(2006.01)}$

(52) Cooperative Patent Classification (CPC):
**H03K 17/9502; H03K 17/952;** H03K 2217/94026

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Optosys SA**
**1720 Corminboeuf (CH)**

(72) Inventor: **Genilloud, Laurent**
**1680 Romont (CH)**

(74) Representative: **AMMANN PATENTANWÄLTE AG**
**Schwarztorstrasse 31**
**3001 Bern (CH)**

(54) **INDUCTIVE PROXIMITY SENSOR WITH TEMPERATURE STABILIZATION**

(57) An inductive proximity sensor for detecting the proximity of an external object, comprises a sensing part (10) including a sensor coil (12) for generating a magnetic field, a first temperature sensor (14) arranged at the sensing part and configured to provide a first temperature signal, at least a second temperature sensor (26) arranged at a distance from the first temperature sensor and configured to provide a second temperature signal, and an evaluation part (20). The latter is configured to provide a primary detection signal based on detected variations of the magnetic field caused by the external object and to correct the primary detection signal based on at least the first and second temperature signals in order to provide an output detection signal which is related to the proximity of the external object and compensated for a temperature change.

Fig. 1

EP 4 611 261 A1

**Description**

The present invention relates to an inductive proximity sensor for detecting the proximity of an external object, comprising a sensing part with a sensor coil for generating a magnetic field.

Such sensors are e.g. configured such that the coil is part of an electrical resonant circuit for generating an alternating magnetic field, which is emitted via the coil. If a metallic or magnetic object enters the effective range of the magnetic field, eddy currents are generated in the object. This alters the magnetic field, and the sensor is able to detect this alteration.

An Inductive proximity sensor may be sensitive to the ambient temperature, such that the detection of an object is not reliable anymore. In order to reduce this sensitivity, a temperature compensation may be implemented, see e.g. the patent US4509023 of the same applicant.

The known measures for temperature compensation only work reliably if the sensor is at temperature equilibrium. However, they fail when the sensor warms up after power is switched on or after a sudden ambient temperature modification. In these cases, a drift in the output signal of the sensor can be seen which is not effectively corrected by the temperature compensation provided.

It is an aim of the present invention to provide for an inductive proximity sensor which generates a reliable output signal even when it is not at temperature equilibrium.

This aim is achieved by an inductive proximity sensor as defined in claim 1. The provision of a first and second temperature sensor allows the evaluation part to correct the primary detection signal in order to provide an output detection signal which is related to the proximity of the object and compensated for a temperature change.

Thus, the proximity sensor may detect a temperature gradient which arises within the sensor when it warms up after switching on and/or when it is subjected to a sudden ambient temperature modification and correct the output signal accordingly.

Preferably, the second temperature sensor may have a minimum distance to the first temperature sensor of at least half of the maximum diameter of the housing of the inductive proximity sensor. More preferably, said minimum distance is at least the maximum diameter of the housing.

The further claims specify preferred embodiments of the inductive proximity sensor and a method of testing such a sensor.

In one embodiment, correction is done by additionally taking the distance of the object to the proximity sensor into account.

The invention is explained in the following by means of exemplary embodiments with reference to Figures. In the drawings:

Fig. 1    shows an embodiment of the proximity sensor according to the invention in a schematic way;

Fig. 2    shows an example of the output signal PD of the proximity sensor, when the temperature gradient within the proximity sensor is not taken into account;

Fig. 3    shows an example of the signals provided by two temperature sensors of the proximity sensor;

Fig. 4    shows the difference of the two signals shown in Fig. 3;

Fig. 5    shows an example of the primary output signal of the proximity sensor, which is uncorrected with regard to temperature variations, and of the wanted signal;

Fig. 6    shows an example of the correction factor in relation to the temperature difference measured;

Fig. 7    shows an example of the uncorrected primary output signal, and the corrected output signal;

Fig. 8    shows an example of the linear coefficient of the correction factor in relation to the uncorrected primary output signal; and

Fig. 9    shows an example of the offset coefficient of the correction factor in relation to the uncorrected primary output signal.

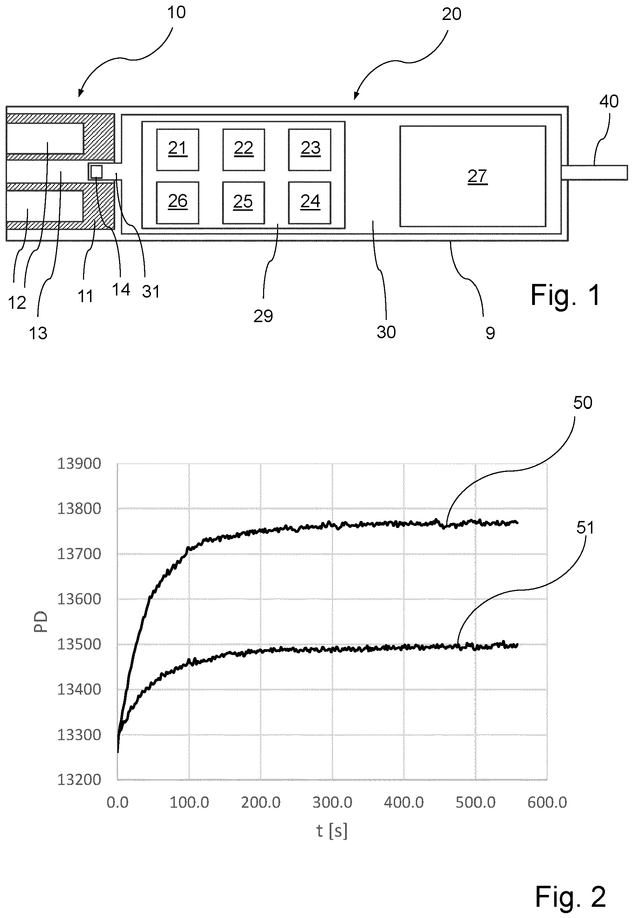

Fig. 1 shows an embodiment of an inductive proximity sensor including a sensing part 10 and an evaluation part 20 arranged in a housing 9.

The sensing part 10 includes a carrier 11 on which a sensing coil 12 is arranged. The carrier 11 includes an opening 13 forming a recess and is e.g. made of ferrite or another material for shaping, in particular focusing the magnetic field emitted by the inductive proximity sensor. In the present embodiment, the carrier 11 is ring-shaped so that opening 13 is part of a through-opening.

At the sensing part 10, there is provided a first temperature sensor 14 for sensing a first temperature which is related to the temperature of the sensing coil 12 and/or the carrier 11. The first temperature sensor 14 is arranged in the opening 13 of the carrier 11. By positioning the first temperature sensor 14 at the sensing part 10, it is possible to gain information on the actual temperature of the coil 12 and/or the carrier 11 to counteract a possible drift in the output signal of the proximity sensor due to temperature changes.

The evaluation part 20 includes a circuitry with the following elements:

- an oscillator 21 which together with the sensing coil 12 is configured to form a resonant circuit, in particular a LC-circuit;
- a signal shaping component 22 for receiving a signal from the resonant circuit and for shaping the signal; preferably the signal shaping component 22 is configured to give a response that is monotonically increasing when the target distance, i.e. the distance between the proximity sensor and an object to be detected, is increasing;
- an output amplifier 23 which amplifies the signal received from the signal shaping component 22; preferably the output amplifier 23 is configured to amplify the signal so that it can be then digitalized;
- a digital part 24 configured to receive signals from the output amplifier 24, from the first temperature sensor 14 and from the second temperature sensor 26, to digitalize those signals and compute a corrected signal;
- a memory 25 for storing information used by the digital part 24;
- a second temperature sensor 26 for sensing a second temperature at a second location;
- additional electronic components 27.

The components 21-26 may be part of an ASIC 29 ("application-specific integrated circuit"). It is conceivable, that some of the components 21-26 are separate components, e.g. the second temperature sensor 26 may be a component separate from the ASIC 29.

The digital part 24 and/or memory 25 may part of a microcontroller for performing a digitalization of the input signals and a computation of the corrected signal.

The components 21-27 are arranged on a circuit board 30, in particular a printed circuit board. In the present embodiment, the circuit board 30 includes a protrusion 31 which extends into the opening 13 and on which the first temperature sensor 14 is arranged.

The proximity sensor includes a transfer part for transferring signals to an external device, e.g. a cable 40 extending from the housing 9 as indicated in Fig. 1 and/or a connector arranged on the housing 9.

In use, an alternating magnetic field is produced by the sensing coil 12 and the oscillator 21 and emitted through the front part of the housing 9. The presence of an object can alter this field and the sensor is able to detect this alteration. The first temperature sensor 14 and second temperature sensor 26 sense the temperature at different locations, which allow the determination of a correction signal as explained hereinafter.

In the diagram shown in Fig. 2, the abscissa represents time in units of seconds, and the ordinate corresponds to the output signal PD of the proximity sensor in arbitrary units in case that the proximity sensor is switched on and no correction with regard to the temperature gradient within the proximity sensor is taken into account. However, the proximity sensor is configured to compensate the signal with regard to the temperature once it has been warmed up and is in thermal equilibrium. To this end, information on a correction for temperature compensation may be stored in the memory 25, e.g. in form of a look-up table that provides a value for a correction parameter for various temperatures. Based on the temperature measured e.g. by the temperature sensor 26, the corresponding correction parameter in the look-up table is determined and used by the digital part 24 to determine a correction in the signal.

Said information on a correction for a proximity sensor of a specific kind may e.g. be obtained from investigating a sample of one or more proximity sensors of the same specific kind (i.e. same components and same dimensions). A proximity sensor of the sample is exposed to different temperatures and its output signal is captured as a standard target is placed at a specific distance in front of the proximity sensor. Subsequently, correction parameters are determined such that the variation of the output signal due to the temperature changes is reduced, preferably minimized. The same correction parameters may be used for each proximity sensor of the same kind.

In Fig. 2, curve 50 is the output signal PD of the proximity sensor when based on the temperature measured by the first temperature sensor 14. Curve 51 is the output signal PD of the proximity sensor when based on the temperature measured by the second temperature sensor 26. As can been seen, curves 50 and 51 fluctuate around a plateau value after a certain time. However, shortly after powering up the proximity sensor, curves 50 and 51 increase sharply.

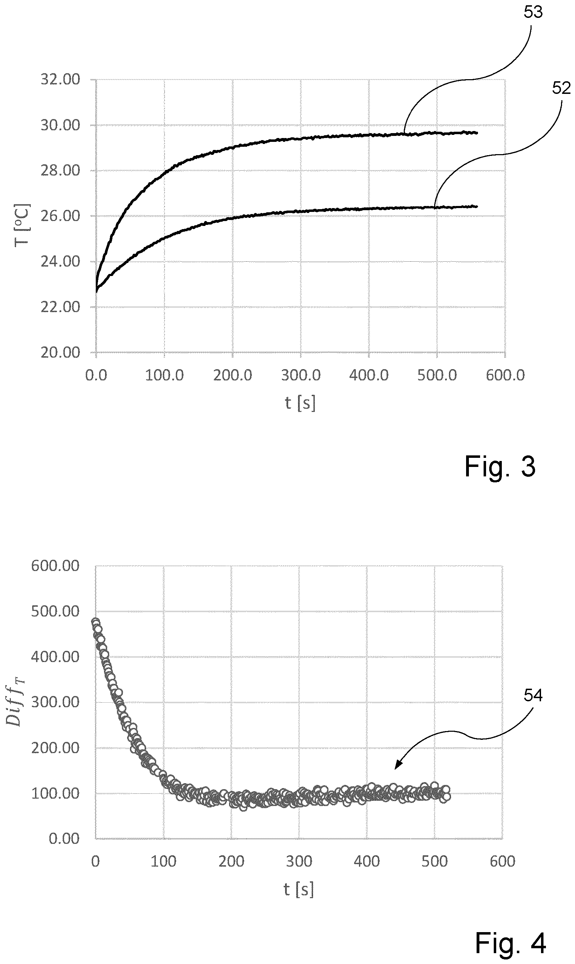

In the diagram shown in Fig. 3, the abscissa represents time t in units of seconds, and the ordinate corresponds to the temperature T in units of degrees Celsius measured when the proximity sensor is switched on. Curve 52 is an example of the time course of the first temperature $T_1$ measured by the first temperature sensor 14. Curve 53 is an example of the time course of the second temperature $T_2$ measured by the second temperature sensor 26. As can been seen, curves 52 and 53 fluctuate around a plateau value after a certain time, i.e. after the warm-up phase. However, in the beginning when powering up the proximity sensor, curves 52 and 53 increase rapidly.

The temperature difference between the two signals provided the temperature sensors 14 and 26 is defined as:

$$Diff_T = T_1 - T_2$$

In the diagram shown in Fig. 4, the abscissa represents time in units of seconds, and the ordinate corresponds to the temperature in arbitrary units. Dots 54 represents the temperature difference $Diff_T$ of the two curves 52 and 53 in Fig. 3. Again, it can be seen that after powering up the proximity sensor at t=0, the temperature difference $Diff_T$ changes considerably and tends to a constant value after a certain time period.

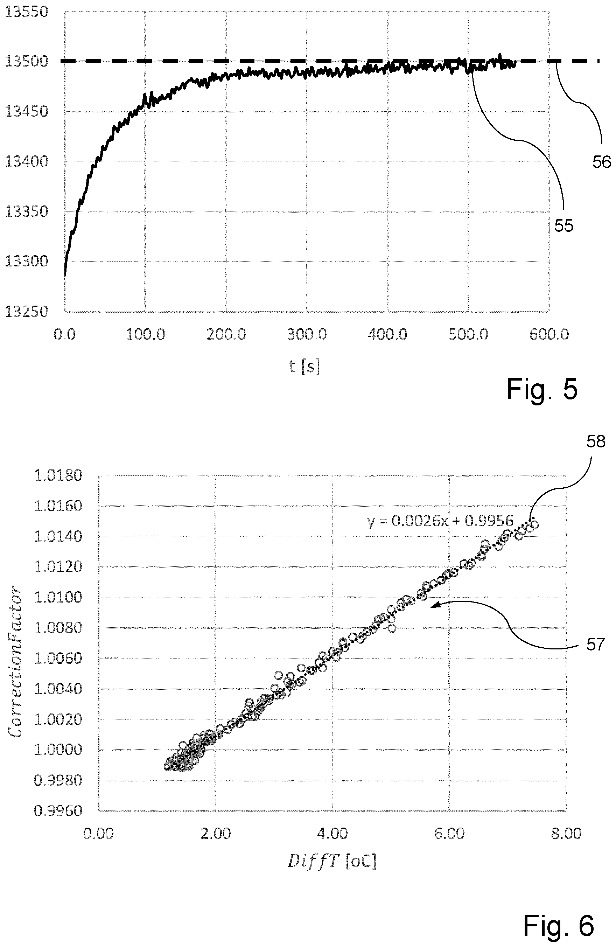

An ideal response of the proximity sensor would be represented by a static output signal independent of the temperature variations within time. Said output signal is in the following denoted by $ProcessData_{target}$ and is indicated in the example of Fig. 5 by the dashed level line 56, wherein the abscissa represents time in units of seconds and the ordinate corresponds to the signal of the proximity sensor PD in arbitrary units.

A correction factor can be defined using the following formula:

$$CorrectionFactor_{meas} = \frac{ProcessData_{target}}{ProcessData_{NC}}$$

where $ProcessData_{NC}$ is the primary output signal of the proximity sensor, i.e. without correction of sudden temperature variations. A correction for gradual temperature changes, which allows the proximity sensor to reach a thermal equilibrium, may be provided. For instance, $ProcessData_{NC}$ may be provided by adjusting an input signal in dependence on the temperature measured by the second temperature sensor 26. In Fig. 5 curve 55 shows an example of the primary output signal $ProcessData_{NC}$.

It has been found that the correction factor $CorrectionFactor_{meas}$ varies essentially in a linear way with respect to the temperature difference measured $Diff_T$. As an example, Fig. 6 shows different dots 57 corresponding to values measured, wherein the abscissa represents the variable $Diff_T$ in units of degrees Celsius, and the ordinate corresponds to the correction factor in arbitrary units. Out of the measured data the two parameters of a linear regression, the linear coefficient (i.e. proportionality factor) $Lin_{DiffT}$ and the offset coefficient (i.e. intercept term) $off_{DiffT}$, can be computed, which allows the determination of the correction factor by the following **equation 1:**

$$CorrectionFactor_{Comp} = Lin_{DiffT} \cdot Diff_T + Off_{DiffT}$$

Line 58 in Fig. 6 indicates the regression line for the data indicated by dots 57.

The parameters $Lin_{DiffT}$ and the intercept term $off_{DiffT}$ can be determined for a specific type of proximity sensor. Based on the equation 1 above and the temperature difference $Diff_T$ measured by the temperature sensors 14, 26 in time, the correction factor $CorrectionFactor_{Comp}$ as a function of time can be determined. Finally, the corrected output signal of the proximity sensor $ProcessData_{corr}$ is determined by means of the following **equation 2:**

$$ProcessData_{Corr} = ProcessData_{NC} \cdot CorrectionFactor_{Comp}$$

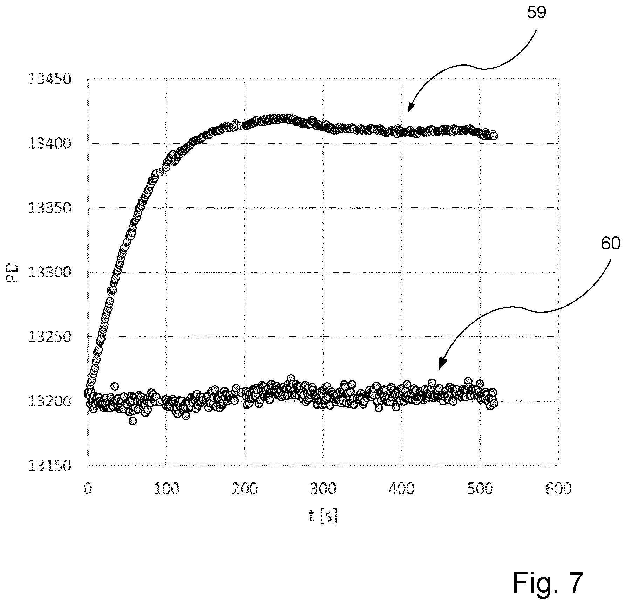

Fig. 7 shows an example of data, wherein the abscissa represents time in units of seconds, and the ordinate corresponds to the signal output in arbitrary units. The dots 59 correspond to the uncorrected data $ProcessData_{Nc}$ and the dots 60 represent the corrected data $ProcessData_{corr}$. As can be seen, variations of the temperature which appear in the proximity sensor after switching it on at t = 0 are substantially balanced out, so that the corrected data $ProcessData_{corr}$ are substantially constant.

As explained so far, the correction factor is considered to be a function of the temperature difference:

$$CorrectionFactor_{Comp} = f(Diff_T)$$

In a further embodiment the actual target distance $S_r$, i.e. the distance between the proximity sensor and the object, can be in addition taken into account to determine the correction factor. The relation between the sensor output and the damping factor implies that the correction factor may be a function of the target distance:

$$CorrectionFactor_{Comp} = f(Diff_T, S_r)$$

As the target distance $S_r$ is related to the primary output of the proximity sensor $ProcessData_{NC}$ this implies that the correction factor is a function of $ProcessData_{Nc}$

$$CorrectionFactor_{Comp} = f(Diff_T, ProcessData_{NC})$$

To determine this function for a specific proximity sensor, a specific target ("test object") is placed at a first distance $S_r$ from the proximity sensor, the latter is switched on and the data for $ProcessData_{Nc}$ and $Diff_T$ are collected. Based on these data the two parameters $Lin_{DiffT}$ and $off_{DiffT}$ of the linear regression are determined. This procedure is repeated for several target distances $S_r$.

It has been found that each of the two parameters $Lin_{DiffT}$ and $off_{DiffT}$ varies essentially in a linear way with respect to the primary output signal $ProcessData_{NC}$.

In one example the following values are obtained:

| Target distance [mm] | $ProcessData_{NC}$ (arbitrary units) | $Lin\_Diff_T$ | $Off\_Diff_T$ |
|---|---|---|---|
| 20 | 13200 | 2.594E-03 | 0.981 |
| 15 | 12400 | 2.205E-03 | 0.982 |
| 10 | 10000 | 1.512E-03 | 0.988 |
| 8 | 8240 | 9.517E-04 | 0.993 |
| 5 | 5394 | 1.122E-04 | 1.000 |

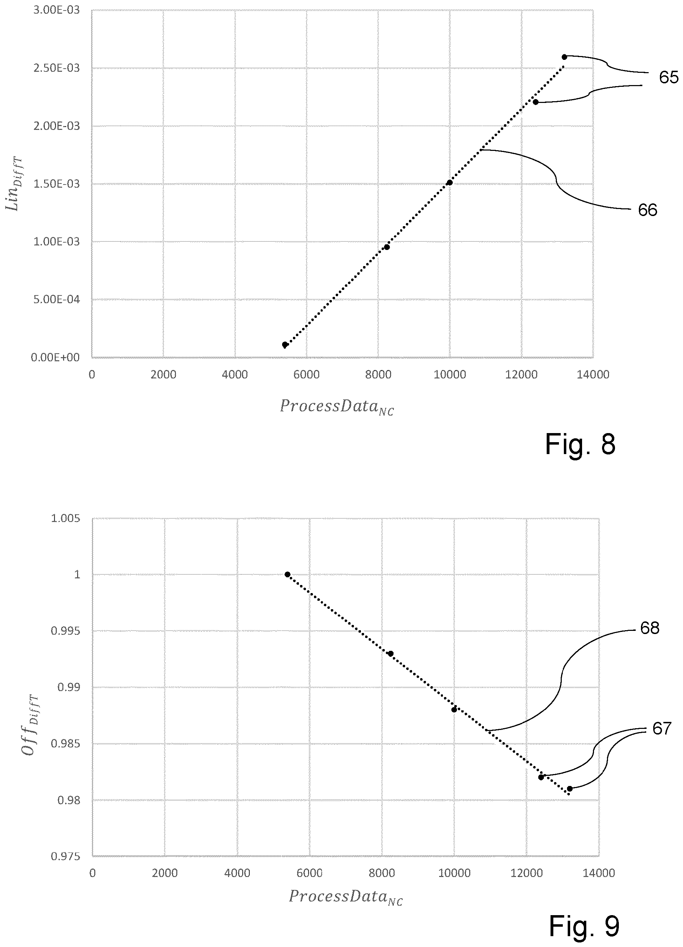

These data are shown in Fig. 8 and 9 by dots 65 and dots 67, respectively, wherein the abscissa represents the primary output of the proximity sensor $ProcessData_{NC}$ in arbitrary units. In Fig. 8 the ordinate corresponds to parameter $Lin_{DiffT}$ in arbitrary units and in Fig. 9 it corresponds to the parameter $Off\_Diff_T$ in arbitrary units. As can be seen, the values 65 and 67, respectively are arranged essentially along a line.

Thus, out of the measured data for $Lin_{DiffT}$ the two parameters of a linear regression, the linear coefficient $Lin\_Lin\_Diff_T$ and the offset coefficient $Off\_Lin\_Diff_T$, can be computed and out of the measured data for $Off\_Diff_T$ the two parameters of a linear regression, the linear coefficient $Lin\_Off\_Diff_T$ and the offset coefficient $off\_off\_Diff_T$, can be computed.

Once these four parameters are determined, the values for $Lin\_Diff_T$ and $Off\_Diff_T$ can be determined for a specific value of $ProcessData_{NC}$ measured. Applying equations 1 and 2 above the $CorrectionFactor_{Comp}$ and finally the corrected $ProcessData_{corr}$ can be determined for a specific value of $Diff_T$ measured.

When producing a particular type of proximity sensor, a test object is placed within the operating distance and the primary output signal of the sensor, i.e. without being compensated for a sudden temperature change, is compared with the wanted signal e.g. during the warm-up phase of the sensor (see Fig. 5). This allows the determination of the correction parameters, such as $Lin_{DiffT}$ and $off_{DiffT}$ and/or $Lin\_Lin\_Diff_T$, $Off\_Lin\_Diff_T$, $Lin\_Off\_Diff_T$ and $Off\_Off\_Diff_T$. If required, the comparison is done for several distances between the test object and the proximity sensor.

The correction parameters are then stored in the memory 25 of the proximity sensor. The memory 25 may be part of a microcontroller of the proximity sensor. It has been found that for proximity sensors of the same type, the same correction parameters can be applied and stored in the respective memory 25.

If a quality test is performed during the fabrication of a series of proximity sensors of a specific type a test object is placed in front of a proximity sensor, the latter is switched on and the output detection signal provided in its warm-up phase is compared with the wanted signal. This test method is time-efficient and thus advantageous with regard to the traditional test procedures applied to proximity sensors having a usual temperature compensation system. Such proximity sensors are first warmed-up before the test can be performed.

The temperature correction measures described herein allows a stabilization of the output of the proximity sensor during the warm-up phase after the sensor has been switched on and/or after a sudden ambient temperature modification. In the particular, the following effects can be counteracted:

- Thermal Inertia:
  A proximity sensor includes various components, such a coil and an electronic circuitry, which have thermal inertia, meaning that they take some time to reach thermal equilibrium with the surrounding environment. During the warm-up phase, these components might still be adjusting to the operating temperature, which - without temperature correction measures - would lead to output fluctuations.

- Rate of temperature change:
  If the proximity sensor is subject to a rapid change in temperature, the present measures provided for a temperature correction make it possible to effectively counteract the temperature-induced variations. It can be avoided that sudden changes in temperature create temporary discrepancies between the actual sensor output and the wanted output. Such temporary discrepancies appear with proximity sensors having a usual temperature compensation system, which need some time until it catches up with the new temperature conditions.

The temperature correction measures described herein to correct the signal can be applied to various types of proximity inductive sensors, e.g. such which are configured as switches or as sensors for determining the distance to an object when located within the operating distance of the proximity sensor. Said temperature correction measures are particularly beneficial for long distance proximity inductive sensors, which have an operating distance of at least 5 mm.

The operating distance of inductive sensors is the distance at which a target approaching the sensing face triggers a signal change.

From the preceding description, many modifications are available to the skilled person without departing from the scope of the invention, which is defined in the claims.

**Claims**

1. An inductive proximity sensor for detecting the proximity of an external object, comprising:

   a sensing part (10) including a sensor coil (12) for generating a magnetic field, the sensing part being arranged inside a front portion of a housing (9);
   a first temperature sensor (14) arranged at the sensing part and configured to provide a first temperature signal;
   at least a second temperature sensor (26) arranged at a distance from the first temperature sensor and configured to provide a second temperature signal; and
   an evaluation part (20) configured to provide a primary detection signal $(ProcessData_{NC})$ based on detected variations of the magnetic field caused by the external object, wherein the evaluation part is configured to correct the primary detection signal based on at least the first and second temperature signals in order to provide an output detection signal which is related to the proximity of the external object and compensated for a temperature change.

2. The inductive proximity sensor according to claim 1, wherein the sensing part (10) includes at least one of the following features A1 to A3:

   A1) the sensing part includes a recess (13) in which the first temperature sensor (14) is arranged;
   A2) the sensing part includes a carrier (11) on which the sensing coil (12) is arranged;
   A3) the carrier of the sensing part is ring-shaped to form the recess.

3. The inductive proximity sensor according to any one of the preceding claims, further including a circuit board (30) which is arranged inside the housing (9) and which includes at least one of the following features B1 to B4:

   B1) the first temperature sensor (14) is arranged on the circuit board;
   B2) the circuit board includes a protrusion (31) extending into a or the recess (13) of the sensing part (10), the first temperature sensor (14) being arranged on the protrusion;
   B3) the second temperature sensor (26) is arranged on the circuit board;
   B4) at least a part of the evaluation part (20) is arranged on the circuit board.

4. The inductive proximity sensor according to any one of the preceding claims, wherein the second temperature sensor (26) includes at least one of the following features C1 to C3:

   C1) the second temperature sensor (26) is arranged inside a rearward portion of the housing (9) adjoining the front portion;
   C2) the second temperature sensor (26) is part of an ASIC (29);
   C3) the second temperature sensor (26) has a minimum distance to the first temperature sensor (14) of at least half of the maximum diameter of the housing (9).

5. The inductive proximity sensor according to any one of the preceding claims, wherein the evaluation part (20) includes at least one of the following features D1 to D6:

> D1) the evaluation part (20) is configured to correct the primary detection signal *(ProcessData$_{NC}$)* in digital form;
> D2) the evaluation part (20) is configured to provide the output detection signal by applying a correction factor *(CorrectionFactor$_{Comp}$)* to the primary detection signal, wherein the correction factor is determined as a function of the first and second temperature signals;
> D3) the evaluation part (20) is configured to provide the output detection signal by applying a correction factor to the primary detection signal, wherein the correction factor is determined as a function of the first and second temperature signals and the primary detection signal;
> D4) the evaluation part (20) is configured to provide the output detection signal as digital data or in analogue form of a voltage output or a current output;
> D5) the evaluation part (20) is configured to produce the primary detection signal by adjusting an input signal in dependence on the first temperature signal or on the second temperature signal;
> D6) the evaluation part (20) is arranged in the housing (9) of the proximity sensor.

6. The inductive proximity sensor according to any one of the preceding claims, wherein the evaluation part (20) comprises a memory (25) in which first correction parameters *(Lin$_{DiffT}$, Off$_{DiffT}$)* are stored, the first correction parameters defining a first linear relationship between the difference between the temperatures determined by the first and second temperature sensors (14, 26) and a or the correction factor *(CorrectionFactor$_{Comp}$)* applied to the primary detection signal *(ProcessData$_{NC}$)*.

7. The inductive proximity sensor according to any one of the preceding claims, wherein the evaluation part (20) is configured to correct the primary detection signal *(ProcessData$_{NC}$)* as a function of the first and second temperature signals and the primary detection signal in order to provide an output detection signal *(ProcessData$_{Corr}$)* which is compensated for a temperature change and a change in the distance between the proximity sensor and the external object.

8. The inductive proximity sensor according to claim 7, wherein the first correction parameters include a linear coefficient *(Lin$_{DiffT}$)* and a offset coefficient *(Off$_{DiffT}$)* of a linear regression, wherein second correction parameters are stored in the memory (25) of the evaluation part (20) which define at least one of a second linear relationship between the linear coefficient and the primary detection signal *(ProcessData$_{NC}$)* and a third linear relationship between the offset coefficient and the primary detection signal.

9. The inductive proximity sensor according to any one of the preceding claims, which is configured to the determine at least one of the

> • the absence or presence of the external object within an operating distance of the proximity sensor, and
> • the distance to the external object when located within the operating distance.

10. A method of testing an inductive proximity sensor according to any one of the preceding claims, wherein a test object to be detected is placed in front of the proximity sensor, the latter is switched on and the output detection signal provided by the inductive proximity sensor in its warm-up phase is compared with a wanted signal.

11. The method according to claim 10, wherein the distance between the test object and the proximity sensor is changed during the warm-up phase of the proximity sensor.

Fig. 1

Fig. 2

Fig. 3

Fig. 4

Fig. 5

Fig. 6

Fig. 7

Fig. 8

Fig. 9

Europäisches
Patentamt

European
Patent Office

Office européen
des brevets

**EUROPEAN SEARCH REPORT**

Application Number

EP 24 16 0712

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/094404 A1 (HASEGAWA RYOTA [JP] ET AL) 28 March 2019 (2019-03-28) | 1-9 | INV. H03K17/95 |
| A | * paragraphs [0010] - [0056]; figures 2,3,6B * | 10,11 | |
| | ----- | | |
| X | JP H08 88555 A (OMRON TATEISI ELECTRONICS CO) 2 April 1996 (1996-04-02) | 1-9 | |
| A | * paragraphs [0009] - [0021]; figure 11 * | 10,11 | |
| | ----- | | |
| X | US 5 895 441 A (BRAULT CHRISTOPHE [FR] ET AL) 20 April 1999 (1999-04-20) | 10,11 | |
| A | * column 1, line 5 - column 4, line 3; figures 1,4 * | 1-9 | |
| | ----- | | |

TECHNICAL FIELDS
SEARCHED (IPC)

H03K

The present search report has been drawn up for all claims

| Place of search | Date of completion of the search | Examiner |
|---|---|---|
| The Hague | 5 November 2024 | Meulemans, Bart |

EPO FORM 1503 03.82 (P04C01)

Europäisches
Patentamt

European
Patent Office

Office européen
des brevets

**Application Number**

EP 24 16 0712

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☒ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

| | | |
|---|---|---|
| Europäisches Patentamt European Patent Office Office européen des brevets | **LACK OF UNITY OF INVENTION**<br>**SHEET B** | **Application Number**<br>EP 24 16 0712 |

The Search Division considers that the present European patent application does not comply with the requirements of unity of invention and relates to several inventions or groups of inventions, namely:

1. claims: 1-9

   Inductive proximity sensor with two temperature sensors and temperature compensation
   - - -

2. claims: 10, 11

   Testing method for a proximity sensor
   - - -

# EP 4 611 261 A1

## ANNEX TO THE EUROPEAN SEARCH REPORT
## ON EUROPEAN PATENT APPLICATION NO.

EP 24 16 0712

This annex lists the patent family members relating to the patent documents cited in  the above-mentioned European search report.
The members are as contained in the European Patent Office EDP file on
The European Patent Office is in no way liable for these particulars which are merely given for the purpose of information.

05-11-2024

| Patent document cited in search report | | Publication date | Patent family member(s) | | Publication date |
|---|---|---|---|---|---|
| US 2019094404 | A1 | 28-03-2019 | CN | 109560803 A | 02-04-2019 |
| | | | DE | 102018103239 A1 | 28-03-2019 |
| | | | JP | 6965658 B2 | 10-11-2021 |
| | | | JP | 2019062268 A | 18-04-2019 |
| | | | KR | 20190035455 A | 03-04-2019 |
| | | | US | 2019094404 A1 | 28-03-2019 |
| JP H0888555 | A | 02-04-1996 | NONE | | |
| US 5895441 | A | 20-04-1999 | BR | 9602096 A | 06-10-1998 |
| | | | CN | 1138248 A | 18-12-1996 |
| | | | DE | 69601385 T2 | 24-06-1999 |
| | | | EP | 0740416 A1 | 30-10-1996 |
| | | | ES | 2126986 T3 | 01-04-1999 |
| | | | FR | 2733617 A1 | 31-10-1996 |
| | | | JP | H0927738 A | 28-01-1997 |
| | | | TR | 199600355 A2 | 21-11-1996 |
| | | | TW | 323338 B | 21-12-1997 |
| | | | US | 5895441 A | 20-04-1999 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4509023 A